# EUROPÄISCHE PATENTSCHRIFT

(11) **EP 1 685 603 B1**
(45) Veröffentlichungstag und Bekanntmachung des Hinweises auf die Patenterteilung: **30.09.2015**
(21) Anmeldenummer: 04791319.9
(22) Anmeldetag: 27.10.2004
(51) Int. Cl.: H01L 33/00, H01L 33/44, H01L 33/62, H01L 31/02

(54) **KOSTENGÜNSTIGE, MINIATURISIERTE AUFBAU- UND VERBINDUNGSTECHNIK FÜR LEDS UND ANDERE OPTOELEKTRONISCHE MODULE**
ECONOMIC MINIATURIZED CONSTRUCTION TECHNIQUE AND CONNECTION TECHNIQUE FOR LEDS AND OTHER OPTO-ELECTRONIC MODULES
TECHNIQUE DE CONNEXION ET DE FABRICATION MINIATURISÉE ET À COÛTS RÉDUITS POUR DES DELS ET D'AUTRES MODULES OPTO-ÉLECTRONIQUES

(30) Priorität: 17.11.2003 DE 10353679
(43) Veröffentlichungstag der Anmeldung: 02.08.2006
(60) Teilanmeldung: 10177356.2
(73) Patentinhaber: OSRAM Opto Semiconductors GmbH, 93055 Regensburg (DE); Siemens Aktiengesellschaft, 80333 München (DE)
(72) Erfinder: GÜNTHER, Ewald, 93128 Regenstauf (DE); SORG, Jörg-Erich, 93053 Regensburg (DE); WEIDNER, Karl, 81245 München (DE); ZAPF, Jörg, 81927 München (DE)
(74) Vertreter: Epping - Hermann - Fischer
(86) Internationale Anmeldenummer: PCT/EP2004/052676
(87) Internationale Veröffentlichungsnummer: WO 2005/050746

(56) Entgegenhaltungen:
- WO-A-02/089221
- WO-A-03/063312
- WO-A-2004/077578
- DE-A1- 3 923 633
- DE-A1- 4 228 274
- JP-A- S58 130 375
- US-A- 4 005 457
- US-A- 5 307 360
- US-A1- 2002 096 254
- US-A1- 2002 137 245
- US-A1- 2003 160 258
- US-A1- 2004 041 159
- US-B1- 6 291 841
- PATENT ABSTRACTS OF JAPAN Bd. 1999, Nr. 08, 30. Juni 1999 (1999-06-30) & JP 11 087779 A (ROHM CO LTD), 30. März 1999 (1999-03-30)
- PATENT ABSTRACTS OF JAPAN Bd. 004, Nr. 112 (E-021), 12. August 1980 (1980-08-12) & JP 55 070080 A (NEC CORP), 27. Mai 1980 (1980-05-27)
- PATENT ABSTRACTS OF JAPAN Bd. 2000, Nr. 19, 5. Juni 2001 (2001-06-05) & JP 2001 044498 A (NICHIA CHEM IND), 16. Februar 2001 (2001-02-16)

## Beschreibung

Bei der Herstellung von einzelnen LEDs und Beleuchtungsmodulen (Compact Light Sources) kommen als elektrische Kontaktiertechniken zwischen Chip und Substrat überwiegend Drahtbonden und Löten bzw. eine Chipmontage mit Leitkleber zum Einsatz. Auf diese Weise entstehen bestückbare Bauelemente oder auch LED-Arrays für Beleuchtungsmodule. Der übliche Aufbauprozess ist wie folgt:
- Diebonden: Platzieren des oder der Chips in einem gefüllten Leitkleber (Kleben) und Aushärten des Klebers oder
- Montage des Chips mit Hilfe eines Lotes, unter Temperatur und möglicherweise Druck (Löten/Legieren),
- Wirebond: Elektrischer Anschluss des Chips durch Drahtkontaktieren,
- Einkapselung des Chips mit transparentem Material (Epoxi, Silikon, Acrylat, Polyurethan und andere Polymere) durch Gießtechnik oder Spritztechnik,
- Vereinzeln der Nutzen durch Sägen, Wasserstrahlschneiden oder Lasertrennen.

Im Zuge der Miniaturisierung werden am Markt immer geringere Bauteilhöhen angefragt. Dabei müssen die Produkte kostengünstig sein und eine ausreichende Zuverlässigkeit bieten. Im Fall von Chip-Arrays werden sogar sehr hohe Zuverlässigkeiten gefordert. Darüber hinaus sollte die Verbindungstechnik eine hohe Flexibilität bieten, um schnell, flexibel und kostengünstig auf Designänderungen reagieren zu können.

JP H11-087779 beschreibt ein Erzeugnis mit einer OLED auf einem Substrat, wobei eine planare Leitstruktur zu einer Kontaktstelle des OLEDs und zu einem leitenden Element auf dem Substrat geführt ist.

DE 4228274 beschreibt ein Erzeugnis mit einem LED-Chip auf einem Substrat, wobei das Substrat und der LED-Chip zumindest teilweise mit einer isolierenden Schicht versehen sind, auf der zur planaren Kontaktierung der LED-Chip eine planare Leitstruktur zu einer Kontaktstelle des LED-Chips und zu einem, auf dem Substrat angeordneten, leitenden Element geführt ist.

Davon ausgehend liegt der Erfindung die Aufgabe zugrunde, Module mit einem Substrat und optoelektronischen Bauelementen sowie Verfahren zu deren Herstellung anzugeben, die diesen Anforderungen gerecht werden.

Diese Aufgabe wird durch die in den unabhängigen Ansprüchen 1 und 9 angegebenen Erfindungen gelöst. Vorteilhafte Ausgestaltungen ergeben sich aus den abhängigen Ansprüchen 2 bis 8.

Dementsprechend weist ein Substrat ein optoelektronisches Bauelement auf, das planar kontaktiert ist. Die Kontaktierung erfolgt also nicht mehr durch dicke, gegebenenfalls im Abstand von Substrat und Bauelement geführte Drähte, sondern durch eine planare, flache, ebene Leitstruktur etwa in Form einer Kupferschicht.

Durch die planare Kontaktierung ergibt sich eine besonders geringe Bauhöhe des Moduls aus Substrat und optoelektronischem Bauelement.

Das optoelektronische Bauelement kann beispielsweise mit anderen optoelektronischen Bauelementen auf dem Substrat kontaktiert sein. Es ist mit leitenden Elementen, beispielsweise Leiterbahnen, des Substrats planar kontaktiert.

Um die planare Kontaktierung in einem möglichst geringem Abstand vom Substrat und/oder optoelektronischen Bauelement zu führen, sind das Substrat und das optoelektronische Bauelement zumindest teilweise mit einer isolierenden Schicht versehen, auf der zur planaren Kontaktierung des optoelektronischen Bauelements die planare Leitstruktur angeordnet ist.

Die isolierende Schicht kann durch eine Folie, Lack und/oder eine Polymerschicht gebildet werden. Die Schicht kann auflaminiert, aufgedampft, gedruckt und/oder gespritzt werden. Eine Strukturierung der isolierenden Schicht kann beispielsweise mittels Laser, (Plasma-)Ätzen, Inkjet und/oder Fotostrukturierung erfolgen. Als Polymer kann insbesondere Parylene verwendet werden.

Dem optoelektronischen Bauelement sollte eine Lichtwechselwirkung mit der Umgebung möglich sein.

Dazu ist die isolierende Schicht im Bereich der Lichtaus- und/oder -eintrittsöffnung des optoelektronischen Bauelementes (hoch-) transparent. Die isolierende Schicht kann aber auch insgesamt (hoch-)transparent sein.

In der isolierenden Schicht kann im Bereich einer oder mehrerer elektrischer Kontaktstellen des optoelektronischen Bauelementes ein Fenster geöffnet sein. Das Fenster kann, beispielsweise wenn die isolierende Schicht durch eine Folie gebildet wird, bereits vor dem Aufbringen der Schicht in dieser vorhanden sein. Alternativ lässt es sich aber auch nach dem Aufbringen der Schicht durch entsprechendes Strukturieren der Schicht mittels der oben genannten Vorgehensweisen öffnen. Durch das Fenster kann dann die planare Leitstruktur zur Kontaktstelle des optoelektronischen Bauelements geführt sein.

Wenn dies beabsichtigt ist, kann die planare Leitstruktur auch die Lichtaus- und/oder -eintrittsöffnung des optoelektronischen Bauelements zumindest teilweise verdecken. Dazu ist insbesondere die planare Leitstruktur reflektierend ausgeführt, so dass beispielsweise Licht in das optoelektronische Bauelement zurückreflektiert wird und dieses an einer anderen Lichtaustrittsöffnung verlassen kann. So lässt sich über die planare Kontaktierung zusätzlich eine Lichtführung erzielen.

Das optoelektronische Bauelement ist beispielsweise eine LED, insbesondere eine OLED, und/oder ein fotovoltaisches Bauelement. Als Substrat können eine Leiterplatte, eine Keramik, eine, insbesondere beidseitig mit Kupfer kaschierte, Flex, ein beispielsweise gestanzter oder geätzter Leadframe oder ein Schichtaufbau zum Einsatz kommen, wie er beispielsweise bei der Herstellung von Chipkarten oder flexiblen Schaltkreisen verwendet wird.

Vorzugsweise beträgt die Höhe des Erzeugnisses mit Substrat und optoelektronischem Bauelement mindestens 150 µm und weniger als 0,4 mm.

In einem Verfahren zum Herstellen eines Erzeugnisses aufweisend ein Substrat mit einem optoelektronischen Bauelement wird das optoelektronische Bauelement planar kontaktiert. Vorteilhafte Ausgestaltungen des Verfahrens ergeben sich analog zu den vorteilhaften Ausgestaltungen des Erzeugnisses und umgekehrt.

Weitere Vorteile und Merkmale der Erfindung lassen sich der Beschreibung von Ausführungsbeispielen anhand der Zeichnung entnehmen. Dabei zeigt:
- Figur 1: einen Schnitt durch ein nicht erfindungsgemäßes Erzeugnis aufweisend ein Substrat mit einem planar kontaktierten optoelektronischen Bauelement;
- Figur 2: einen Schnitt durch ein erfindungsgemäßes Erzeugnis aufweisend ein Substrat mit einem planar kontaktierten optoelektronischen Bauelement;
- Figur 3: einen Vergleich zwischen dem planar und einem herkömmlich kontaktierten optoelektronischen Bauelement in der Draufsicht und
- Figur 4: einen Vergleich zwischen dem planar und dem herkömmlich kontaktierten optoelektronischen Bauelement bezüglich des Lichtausfalls.

Zunächst sollen einige Grundzüge der Aufbau- und Verbindungstechnik dargestellt werden.

Eines oder mehrere optoelektronische Bauelemente beispielsweise in Form von Chips werden durch Kleben oder Löten auf einem Substrat fixiert. Die elektrische Anbindung von Kontaktstellen in Form von Kontaktpads auf der Oberseite des optoelektronischen Bauelements erfolgt nun durch ein planares Kontaktierverfahren. Dieses kann zum Beispiel auf dem Auflaminieren einer elektrisch isolierenden Folie und der Kontaktierung durch planare Leitstrukturen in Form von Metallstrukturen auf dieser Folie basieren. Statt in Form einer isolierenden Folie kann eine isolierende Schicht allerdings auch durch andere Verfahren erzeugt werden, wie beispielsweise Lackieren, Aufdampfen oder Drucken.

Zur isolierenden Schicht in Form von Isolierfolie:
- Aufbringen zum Beispiel durch isostatisches Laminieren in einem Autoklaven oder durch Verwendung eines Hot-Roll-Laminators oder in einer Vakuum-Heißpresse.
- Die Folie ist im Wellenlängenbereich des vom optoelektronischen Bauelement emittierten oder absorbierten Lichts transparent sein. Die Folie kann dann auch die Schutzfunktion des Clear-Mold-Compounds mit übernehmen.
- Durch geeignete Laminierverfahren kann erreicht werden, dass die Isolierfolie die Chipoberfläche nachbildet. Damit kann erreicht werden, dass auch an den Kanten und in den Eckbereichen die volle Isolierfunktion zur Erhöhung der Zuverlässigkeit gegeben ist.

Zur Kontaktierung durch planare Leitstrukturen in Form von Metallstrukturen gibt es verschiedene Möglichkeiten:
- Elektrische Anbindung über einen geeigneten Metallisierungsprozess, zum Beispiel Aufbringen einer dünnen Startschicht durch Sputtern oder Aufdampfen, anschließend selektive Verstärkung durch stromlose oder galvanische Abscheidung zum Beispiel von Kupfer.
- Die Isolierfolie ist elektrisch leitfähig beschichtet, zum Beispiel durch Aufkaschieren einer Metallfolie. Diese Metallfolie wird nun vor oder nach dem Laminierprozess strukturiert. Die Verbindung zwischen Chip und Metallstruktur kann bei erhöhten, besonders rauen Bumps auf den Chip-Pads durch mechanisches Verpressen erfolgen oder auch durch partielle galvanische oder stromlose Abscheidung. Hierbei ist eine Veredelung der Aluminium-Chip-Pads auf Waferebene vorteilhaft.
- Die Verbindung kann auch durch Einsatz von vorgeformten Presswerkzeugen in handelsüblichen Pressen erfolgen.
- Die leitfähigen Metallstrukturen können durch einen Druckprozess aufgebracht werden.

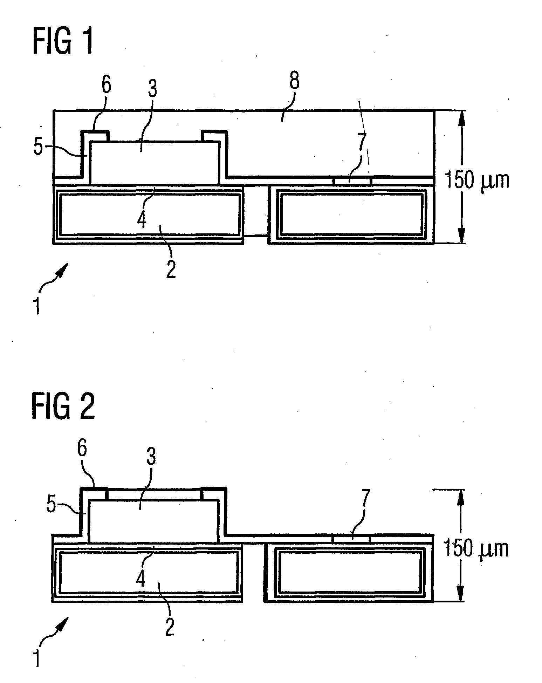

In Figur 1 erkennt man ein nicht erfindungsgemäßes Erzeugnis 1 aufweisend ein Substrat 2 in Form eines geätzten Kupfer-Leadframes. Das Kupfer des Leadframes ist dabei mit einer Nickel-Gold-Galvanik umgeben, um die Löteigenschaften zu verbessern. Auf dem Substrat 2 ist ein optoelektronisches Bauelement 3 in Form eines Chips angeordnet und mit dem Substrat 2 über Leitkleber oder Lot 4 elektrisch und mechanisch verbunden.

Über das Substrat 2 und das optoelektronische Bauelement 3 ist eine isolierende Schicht 5 in Form einer Folie geführt. Die isolierende Schicht 5 ist im Bereich der Lichtaustrittsöffnung des optoelektronischen Bauelements 3 durch ein Fenster geöffnet. Zur Kontaktierung des optoelektronischen Bauelements 3 ist eine planare Leitstruktur 6 in Form einer Metallisierung über die isolierende Schicht 5 zu Kontaktstellen des optoelektronischen Bauelements 3 und zu einer Leiterbahn 7 des Substrats 2 geführt.

Das Substrat 2 mit dem optoelektronischen Bauelement 3, der isolierenden Schicht 5 und der planaren Leitstruktur 6 sind in eine Schutzmasse 8 in Form eines Clear-Mold-Compounds eingegossen. Das Erzeugnis 1 ist etwa 150 µm hoch.

Das in Figur 2 dargestellte erfindungsgemäße Erzeugnis 1 entspricht dem in Figur 1 dargestellten mit Ausnahme der Tatsache, dass die isolierende Schicht 5 transparent ausgeführt ist und deshalb im Bereich der Lichtaustrittsöffnung des optoelektronischen Bauelements 3 durchläuft. Es ist dort also kein Fenster geöffnet, sondern nur an den Kontaktstellen des optoelektronischen Bauelements 3, an denen dieses mit der planaren Leitstruktur 6 elektrisch verbunden ist. Die transparente, isolierende Schicht 5 enthält im Bereich der Lichtaustrittsöffnung des optoelektronischen Bauelements 3 Pigmente, um austretendes Licht zu färben.

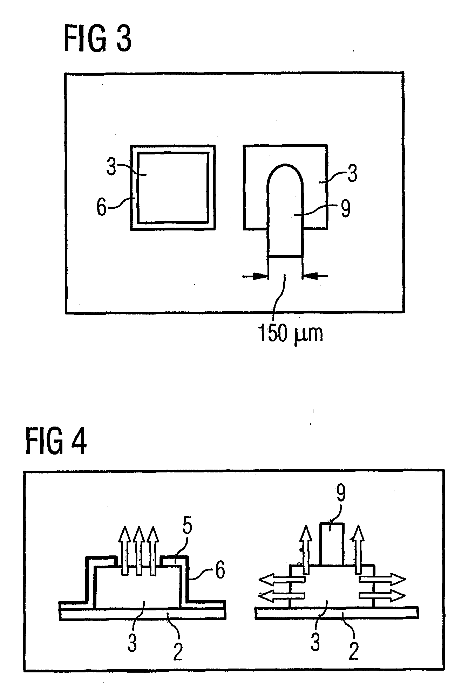

In Figur 3 erkennt man links ein planar kontaktiertes optoelektronisches Bauelement 3 mit einem großen zentralen Lichtaustritt und einer diesen Lichtaustritt vollkommen umgebenden Randkontaktierung mit einer planaren Leitstruktur 6 und einer darunter verborgenen isolierenden Schicht. Alternativ kann die Randkontaktierung je nach Aufbau der Kontaktstellen des optoelektronischen Bauelements 3 und beabsichtigter Lichtführung auch nicht vollständig umlaufend, sondern nur an einer oder mehreren einzelnen Stellen zur dem Substrat 2 abgewandten Stirnseite des optoelektronischen Bauelements 3 laufen.

Rechts sieht man in Figur 3 ein optoelektronisches Bauelement 3, das nach dem Stand der Technik über 120 µm-Drahtbonden mit einem Draht 9 kontaktiert ist. Wie man erkennt, wird ein Großteil der Lichtaustrittsöffnung des optoelektronischen Bauelements 3 verdeckt.

Die Vorteile der planaren Kontaktierung bei der Lichtführung werden in Figur 4 besonders deutlich. Hier sieht man links wiederum das planar durch die isolierende Schicht 5 und die planare Leitstruktur 6 kontaktierte optoelektronische Bauelement 3 auf dem Substrat 2. Alle Lichtaustrittsöffnungen des optoelektronischen Bauelements 3, an denen ein Lichtaustritt nicht gewünscht wird, werden durch die isolierende Folie 5 und die planare Leitstruktur 6 verdeckt. Sind diese reflektierend ausgeführt, so wird das Licht sogar in das optoelektronische Bauelement 3 zurückreflektiert, bis es an der vorgesehenen Lichtaustrittsöffnung austritt.

Bei der rechts in Figur 4 dargestellten Kontaktierung nach dem Stand der Technik wird dagegen ein großer Teil des gewünschten Lichtaustrittsbereichs durch den angebondeten Draht 9 verdeckt. Stattdessen tritt das Licht ungewünscht parallel zum Substrat 2 aus den Seiten des optoelektronischen Bauelements 3 aus.

Beim planar kontaktierten optoelektronischen Bauelement 3 tritt das Licht dagegen wie gewünscht an der dem Substrat 2 gegenüber liegenden Stirnfläche des optoelektronischen Bauelements 3 und damit in etwa senkrecht zum Substrat 2 aus.

Die beschriebene Aufbau- und Verbindungstechnik weist folgende Vorteile auf:
- Kleinflächige Ankontaktierung und ein variables Layout ermöglichen größtmögliche Lichtausbeuten.
- Homogene Stromverteilung durch ausgewählte Kontaktleiterdimensionen mit der Folge einer hohen Lichtausbeute.
- Ultradünner, miniaturisierter Aufbau.
- Planare Ankontaktierung ermöglicht dünne Moldmassenabdeckung.
- Planare Ankontaktierung ermöglicht eine effektive Entwärmung durch einen flächig angebrachten Kühlkörper
- Kostengünstige Aufbau- und Verbindungstechnik durch hochparallele Prozessierung (Prozessierung im Nutzen). Auch das Fertigen im Reel-to-Reel-Verfahren ist möglich.
- Keine Abschattung durch zentrale Wirebond-Pads in der Chipmitte.
- Hohe Zuverlässigkeit durch angepasste Materialeigenschaften, zum Beispiel CTE (Coeffizient of Thermal Expansion), Tg (Temperatur des Glasübergangs) usw.
- Bei geeigneter Wahl der optischen Eigenschaften der Isolierfolie kann diese die Schutzfunktion des Clear-Mold-Compounds mit übernehmen, so dass dieser nicht mehr notwendig ist.
- Die Leuchtstoffe für die Lichtkonversion blau zu weiß können als Pigmente in die Folie eingearbeitet werden. Auf diese Weise ist über eine genau bestimmte Foliendicke und Pigmentkonzentration in der Folie eine gute Steuerung der Farbkoordinaten möglich.

## Patentansprüche

1. Erzeugnis aufweisend ein Substrat (2) mit einem optoelektronischen Bauelement (3), wobei
- das Substrat ein elektrisch leitendes Element (7) aufweist, und
- das Substrat (2) und das optoelektronische Bauelement (3) zumindest teilweise mit einer isolierenden Schicht (5) versehen sind, auf der zur planaren Kontaktierung des optoelektronischen Bauelements (3) eine planare Leitstruktur (6) zu einer Kontaktstelle des optoelektronischen Bauelements (3) und zu dem leitenden Element (7) geführt ist,
**dadurch gekennzeichnet,**
**dass** die isolierende Schicht (5) im Bereich einer Lichtaus- und/oder -eintrittsöffnung des optoelektronischen Bauelements (3) transparent ist und Pigmente zur Färbung des vom optoelektronischen Bauelement (3) emittierten oder absorbierten Lichts enthält.

2. Erzeugnis nach Anspruch 1,
**dadurch gekennzeichnet,**
**dass** die isolierende Schicht (5) eine Folie, Lack und/oder eine Polymerschicht ist.

3. Erzeugnis nach einem der vorhergehenden Ansprüche,
**dadurch gekennzeichnet,**
**dass** in der isolierenden Schicht (5) im Bereich der Kontaktstelle des optoelektronischen Bauelements (3) ein Fenster geöffnet ist, durch das die planare Leitstruktur zur Kontaktstelle (3) des optoelektronischen Bauelements geführt ist.

4. Erzeugnis nach einem der vorhergehenden Ansprüche,
**dadurch gekennzeichnet,**
**dass** die planare Kontaktierung die Lichtaus- und/oder - eintrittsöffnung des optoelektronischen Bauelements zumindest teilweise verdeckt.

5. Erzeugnis nach einem der vorhergehenden Ansprüche,
**dadurch gekennzeichnet,**
**dass** das optoelektronische Bauelement (3) eine LED, insbesondere eine OLED, und/oder ein fotovoltaisches Bauelement ist.

6. Erzeugnis nach einem der vorhergehenden Ansprüche,
**dadurch gekennzeichnet,**
**dass** das Substrat (2) eine Leiterplatte, eine Flex oder ein Leadframe ist.

7. Erzeugnis nach einem der vorhergehenden Ansprüche,
**dadurch gekennzeichnet,**
**dass** das leitende Element (7) eine Leiterbahn ist.

8. Erzeugnis nach einem der vorhergehenden Ansprüche,
**dadurch gekennzeichnet,**
**dass** die Höhe des Erzeugnisses (1) mindestens 150 µm und weniger als 0,4 mm beträgt.

9. Verfahren zum Herstellen eines Erzeugnisses (1) aufweisend ein Substrat (2) mit einem optoelektronischen Bauelement (3), wobei das optoelektronische Bauelement (3) planar elektrisch kontaktiert wird, indem
- das Substrat (2) und das optoelektronische Bauelement (3) zumindest teilweise mit einer isolierenden Schicht (5) versehen werden, und
- eine planare Leitstruktur (6) von einer Kontaktstelle des optoelektronischen Bauelements (3) über die isolierende Schicht (5) zu einem leitenden Element (7), insbesondere einer Leiterbahn, auf dem Substrat (2) geführt wird,
**dadurch gekennzeichnet,**
**dass** die isolierende Schicht (5) im Bereich einer Lichtaus- und/oder -eintrittsöffnung des optoelektrinischen Bauelements (3) transparent ist und Pigmente zur Färbung des vom optoelektronischen Bauelement (3) emittierten oder absorbierten Lichts in die isolierende Schicht (5) eingearbeitet werden.

## Claims

1. Product having a substrate (2) with an optoelectronic component (3), wherein
- the substrate has an electrically conductive element (7), and
- the substrate (2) and the optoelectronic component (3) are provided with an insulating layer (5) at least in parts, on which insulating layer a planar conductor structure (6) is guided, in order to make planar contact with the optoelectronic component (3), to a contact point of the optoelectronic component (3) and to the conductive element (7),
**characterized**
**in that** the insulating layer (5) is transparent in the region of a light-exit and/or light-inlet opening of the optoelectronic component (3) and contains pigments for colouring the light emitted or absorbed by the optoelectronic component (3).

2. Product according to Claim 1,
**characterized**
**in that** the insulating layer (5) is a foil, lacquer and/or a polymer layer.

3. Product according to either of the preceding claims,
**characterized**
**in that** a window is opened in the insulating layer (5) in the region of the contact point of the optoelectronic component (3), through which window the planar conductor structure is guided to the contact point (3) of the optoelectronic component.

4. Product according to any of the preceding claims,
**characterized**
**in that** the planar contact at least partially covers the light-exit and/or light-inlet opening of the optoelectronic component.

5. Product according to any of the preceding claims,
**characterized**
**in that** the optoelectronic component (3) is an LED, in particular an OLED, and/or a photovoltaic component.

6. Product according to any of the preceding claims,
**characterized**
**in that** the substrate (2) is a printed circuit board, a flex or a lead frame.

7. Product according to any of the preceding claims,
**characterized**
**in that** the conductive element (7) is a conductor track.

8. Product according to any of the preceding claims,
**characterized**
**in that** the height of the product (1) is at least 150 µm and less than 0.4 mm.

9. Method for producing a product (1) having a substrate (2) with an optoelectronic component (3), wherein electrical planar contact is made with the optoelectronic component (3) by
- the substrate (2) and the optoelectronic component (3) being provided with an insulating layer (5) at least in parts, and
- a planar conductor structure (6) being guided from a contact point of the optoelectronic component (3) via the insulating layer (5) to a conductive element (7), in particular a conductor track, on the substrate (2),
**characterized**
**in that** the insulating layer (5) is transparent in the region of a light-exit and/or light-inlet opening of the optoelectronic component (3) and pigments for colouring the light emitted or absorbed by the optoelectronic component (3) are incorporated into the insulating layer (5).

## Revendications

1. Produit possédant un substrat (2) muni d'un composant optoélectronique (3),
- le substrat possédant un élément (7) électriquement conducteur, et
- le substrat (2) et le composant optoélectronique (3) étant au moins partiellement munis d'une couche isolante (5) sur laquelle, en vue de l'établissement d'un contact planaire avec le composant optoélectronique (3), une structure conductrice planaire (6) est acheminée à un point de contact du composant optoélectronique (3) et à l'élément conducteur (7),
**caractérisé en ce**
**que** la couche isolante (5) est transparente dans la zone d'une ouverture de sortie et/ou d'entrée de lumière du composant optoélectronique (3) et contient des pigments destinés à colorer la lumière émise ou absorbée par le composant optoélectronique (3).

2. Produit selon la revendication 1, **caractérisé en ce que** la couche isolante (5) est un film, une laque et/ou une couche en polymère.

3. Produit selon l'une des revendications précédentes, **caractérisé en ce que** dans la couche isolante (5), dans la zone du point de contact du composant optoélectronique (3), est ouverte une fenêtre à travers laquelle la structure conductrice planaire est acheminée au point de contact (3) du composant optoélectronique.

4. Produit selon l'une des revendications précédentes, **caractérisé en ce que** l'établissement du contact planaire recouvre au moins partiellement l'ouverture de sortie et/ou d'entrée de lumière du composant optoélectronique.

5. Produit selon l'une des revendications précédentes, **caractérisé en ce que** le composant optoélectronique (3) est une LED, notamment une OLED, et/ou un composant photovoltaïque.

6. Produit selon l'une des revendications précédentes, **caractérisé en ce que** le substrat (2) est un circuit imprimé, un circuit souple ou une grille de connexion.

7. Produit selon l'une des revendications précédentes, **caractérisé en ce que** l'élément conducteur (7) est une piste conductrice.

8. Produit selon l'une des revendications précédentes, **caractérisé en ce que** la hauteur du produit (1) est au minimum de 150 µm et inférieure à 0,4 mm.

9. Procédé de fabrication d'un produit (1) possédant un substrat (2) muni d'un composant optoélectronique (3), un contact électrique planaire étant établi avec le composant optoélectronique (3) en ce que
- le substrat (2) et le composant optoélectronique (3) sont au moins partiellement munis d'une couche isolante (5), et
- une structure conductrice planaire (6) est acheminée par le biais de la couche isolante (5) d'un point de contact du composant optoélectronique (3) à un élément conducteur (7), notamment une piste conductrice, sur le substrat (2),
**caractérisé en ce**
**que** la couche isolante (5) est transparente dans la zone d'une ouverture de sortie et/ou d'entrée de lumière du composant optoélectronique (3) et des pigments destinés à colorer la lumière émise ou absorbée par le composant optoélectronique (3) sont incorporés dans la couche isolante (5).
